(19) Europäisches Patentamt
European Patent Office
Office européen des brevets

(11) **EP 4 700 418 A1**

(12) **EUROPEAN PATENT APPLICATION**
published in accordance with Art. 153(4) EPC

(43) Date of publication:
**25.02.2026 Bulletin 2026/09**

(21) Application number: **24792326.1**

(22) Date of filing: **02.02.2024**

(51) International Patent Classification (IPC):
**G01R 33/20** (2006.01)   **C30B 29/04** (2006.01)
**G01R 29/08** (2006.01)

(52) Cooperative Patent Classification (CPC):
**C30B 29/04; G01R 29/08; G01R 33/20**

(86) International application number:
**PCT/JP2024/003395**

(87) International publication number:
**WO 2024/219050 (24.10.2024 Gazette 2024/43)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **18.04.2023 JP 2023067532**

(71) Applicants:
• **Nissin Electric Co., Ltd.**
  **Kyoto-shi, Kyoto 615-8686 (JP)**
• **Sumitomo Electric Industries, Ltd.**
  **Osaka-shi, Osaka 541-0041 (JP)**

(72) Inventors:
• **TATSUMI, Natsuo**
  **Kyoto-shi, Kyoto 615-8686 (JP)**
• **HAYASHI, Tsukasa**
  **Kyoto-shi, Kyoto 615-8686 (JP)**
• **DEGUCHI, Hiroshige**
  **Kyoto-shi, Kyoto 615-8686 (JP)**
• **NISHIBAYASHI, Yoshiki**
  **Osaka-shi, Osaka 541-0041 (JP)**

(74) Representative: **Boult Wade Tennant LLP**
**Salisbury Square House**
**8 Salisbury Square**
**London EC4Y 8AP (GB)**

(54) **DIAMOND SPIN SENSOR AND METHOD FOR MANUFACTURING SAME**

(57)   A diamond spin sensor includes a diamond substrate and an inclined surface formed on the diamond substrate. Color centers with electron spin are formed on the inclined surface. Among the color centers formed on the inclined surface, color centers with a color center axis perpendicular to the inclined are present in a proportion twice or more color centers with a color center axis not perpendicular to the inclined surface.

FIG.1

EP 4 700 418 A1

**Description**

TECHNICAL FIELD

The present disclosure relates to a diamond spin sensor and a method of producing the same. This application claims priority based on Japanese Patent Application No. 2023-067532, filed on April 18, 2023, the entire contents of which are hereby incorporated by reference.

BACKGROUND ART

Diamond spin sensors using diamond NV centers (hereafter referred to as NV centers) are known. When the NV center, which consists of a nitrogen atom (i.e., N) that substitutes for a carbon atom (i.e., C) in diamond and a vacancy (i.e., V) adjacent to the nitrogen atom, is negatively charged, its ground state becomes a triplet state (i.e., the spin S is S=1). The negatively charged NV center, which is denoted as NV$^-$center, will also be referred to as NV center in the following. When excited by a wavelength of 532 nm (i.e., green light), the charged NV center emits fluorescence at a wavelength of 637 nm (i.e., red light). The emission intensity of the fluorescence changes with a spin state, and the spin state changes with magnetic resonance due to a magnetic field applied to the NV center and microwaves or radio waves, and can be used as a magnetic sensor.

In detection, the following are used: a diamond substrate containing NV centers as a diamond spin sensor, an optical system that transmits excitation light from a light source to irradiate NV centers, an optical system that collects fluorescence from NV centers and transmits the fluorescence to a photodetector, and a waveguide that transmits microwaves from a power source to irradiate NV centers.

CITATION LIST

NON PATENT LITERATURE

NPL 1: M. Lesik, J.-P. Tetienne, A. Tallaire, J. Achard, V, Mille, A. Gicquel, J.-F. Roch, V. Jacques, "Perfect preferential orientation of nitrogen-vacancy defects in a synthetic diamond sample", Appl. Phys. Lett. 104, 113107 (2014).
NPL 2: Yuta Nakano, Shu Inagaki, Kazuki Kobayashi, Moriyoshi Haruyama, Hiromitsu Kato, Christoph E. Nebel, Xufang Zhang, Tsubasa Matsumoto, Takao Inokuma, Satoshi Yamasaki, Norio Tokuda, "Development of heavily nitrogen-doped diamond growth with suppression of 2D nucleation", Proceedings of the 69th JSAP (the Japan Society of Applied Physics) Spring Meeting (2022) 25a-E204-1
NPL 3: M. W. Doherty, V. M. Acosta, A. Jarmola, M. S. J. Barson, N. B. Manson, D. Budker, and L. C. L. Hollenberg, "Temperature shifts of the resonances of the NV- center in diamond", PHYSICAL REVIEW B 90, 041201(R) (2014).

SUMMARY OF INVENTION

A diamond spin sensor according to an aspect of the present disclosure includes a diamond substrate and an inclined surface formed on the diamond substrate, wherein color centers with electron spin are formed on the inclined surface, and among the color centers formed on the inclined surface, color centers with a color center axis perpendicular to the inclined surface are present in a proportion twice or more color centers with a color center axis not perpendicular to the inclined surface.

BRIEF DESCRIPTION OF DRAWINGS

[Fig. 1] Fig. 1 is a perspective view showing a diamond spin sensor according to an embodiment.

[Fig. 2] Fig. 2 is a diagram schematically showing crystal planes of diamond.

[Fig. 3] Fig. 3 is a block diagram showing a configuration of a device used in measurement using the diamond sensor shown in Fig. 1.

[Fig. 4] Fig. 4 is a sequence diagram showing the irradiation timing of excitation light and electromagnetic waves and the measurement timing of emitted light during measurement using the diamond spin sensor shown in Fig. 1.

[Fig. 5] Fig. 5 is a graph schematically showing a relation between the observed signal intensity (i.e., emitted light intensity) and the frequency of electromagnetic waves (i.e., microwaves).

[Fig. 6] Fig. 6 is a perspective view showing measurement of a magnetic field and an electric field using the diamond spin sensor shown in Fig. 1.

[Fig. 7] Fig. 7 is a diagram schematically showing an NV center of diamond.

[Fig. 8] Fig. 8 is a perspective view showing a relation between four possible directions of the NV axis of diamond and a magnetic field in the <100> direction.

[Fig. 9] Fig. 9 is a graph schematically showing a relation between the observed signal intensity and the electromagnetic wave frequency in a state in Fig. 8.

[Fig. 10] Fig. 10 is a perspective view showing a relation between four possible directions of the NV axis of diamond and a magnetic field in the <110> direction.

[Fig. 11] Fig. 11 is a graph schematically showing a relation between the observed signal intensity and the electromagnetic wave frequency in a state in Fig. 10.

[Fig. 12] Fig. 12 is a perspective view showing a relation between four possible directions of the NV axis of diamond and a magnetic field in the <111> direction.

[Fig. 13] Fig. 13 is a graph schematically showing a relation between the observed signal intensity and the electromagnetic wave frequency in a state in Fig. 12.

[Fig. 14] Fig. 14 is a diagram schematically showing a method of producing a diamond spin sensor.

[Fig. 15] Fig. 15 is a diagram schematically showing a method of producing a diamond spin sensor which is different from that of Fig. 14.

DETAILED DESCRIPTION

[Problem to be Solved by the Present Disclosure]

The axis passing through N and V of the NV center formed in diamond (hereafter referred to as the NV axis) can take four directions from the crystal structure of diamond. Since the sensitivity as a sensor depends on the direction of the NV axis relative to a target to be detected (e.g., magnetic field or electric field), it is preferable to align the NV axis. For example, the NV axis can be aligned in a direction perpendicular to a (111) crystal plane by chemical vapor deposition (CVD). However, a sufficient signal-to-noise ratio is unable to be obtained because the total number of NV centers is small and the amount of fluorescence is weak. Moreover, in CVD growth, abnormal growth tends to occur, making it difficult to form a thick film with NV centers aligned in the NV axis direction. Diamond with a (111) crystal plane on its surface is small in size, and it is difficult to obtain a large substrate, leading to high costs. Another method is to perform patterning on a substrate with a (100) crystal plane of a large size to allow NV-oriented growth. However, this method forms NV centers facing four directions, and it is difficult to align the NV axis and impart anisotropy. These problems are not limited to NV centers and also occur in diamonds having color centers with electron spin.

Therefore, it is an object of the present disclosure to provide a diamond spin sensor having a color center with an aligned color center axis and capable of improving detection sensitivity, and a method of producing the same.

[Advantageous Effect of the Present Disclosure]

The present disclosure can provide a diamond spin sensor having a color center with an aligned color center axis and capable of improving detection sensitivity, and a method of producing the same.

[Description of Embodiments of the Present Disclosure]

The contents of the embodiments of the present disclosure will be described in order. At least some of the embodiments described below may be combined as desired.

(1) A diamond spin sensor according to a first aspect of the present disclosure includes a diamond substrate and an inclined surface formed on the diamond substrate, wherein color centers with electron spin are formed on the inclined surface, and among the color centers formed on the inclined surface, color centers with a color center axis perpendicular to the inclined surface are present in a proportion twice or more color centers with a color center axis not perpendicular to the inclined surface. This configuration provides a diamond spin sensor having a plurality of color centers aligned in the color center axis and capable of improving detection sensitivity.

(2) In (1) above, the color centers may include $NV^{-}$ centers. This configuration provides a diamond spin sensor having a plurality of $NV^{-}$ centers aligned in the axis of the $NV^{-}$ centers and capable of improving detection sensitivity.

(3) In (1) or (2) above, the inclined surface may include a first inclined surface and a second inclined surface. The second inclined surface may be disposed on back of the first inclined surface. The first inclined surface may have a (111) crystal plane. The second inclined surface may have a (-1-11) crystal plane. Among the color centers formed on the first inclined surface, color centers with a color center axis perpendicular to the first inclined surface may be present in a proportion twice or more color centers with a color center axis not perpendicular to the first inclined surface. Among the color centers formed on the second inclined surface, color centers with a color center axis perpendicular to the second inclined surface may be present in a proportion twice or more color centers with a color center axis not perpendicular to the second inclined surface. This configuration allows sensitivity in two directions and enables a magnetic field and an electric field to be independently detected. In addition, temperature can be measured without being affected by a magnetic field. The notation "-1" corresponds to the notation with a bar (horizontal bar) above 1.

(4) In (3) above, in measuring an electric field formed by current flowing through a predetermined portion of a conductive line, the diamond spin sensor may be disposed with respect to the conductive line such that the predetermined portion is located in a plane defined by a <111> direction which is a direction normal to the first inclined surface and a <-1-11> direction which is a direction normal to the second inclined surface. This configuration enables accurate measurement of an electric field formed by current flowing through a predetermined portion of a conductive line.

(5) A method of producing a diamond spin sensor according to a second aspect of the present disclosure includes: a preparation step of preparing a substrate of a single crystal diamond having a (001) crystal plane on a surface; a crystal plane forming step of forming a (111) crystal plane and a (-1-11) crystal plane on the surface of the substrate; and an NV forming step of forming NV centers on the (111) crystal plane and the (-1-11) crystal plane by CVD. This method can produce a diamond spin sensor having a plurality of color centers aligned in the color center axis and capable of improving detection sensitivity. Diamond substrates having (100) crystal planes, relatively large in size, can be easily obtained, facilitating the production of diamond spin sensors.

(6) In (5) above, the method may further include, between the preparation step and the crystal plane forming step, a step of forming a mask with a predetermined width extending along a <1-10> direction on the (001) crystal plane; an etching step of etching the (001) crystal plane having the mask formed thereon; and a step of removing the mask remaining after the etching, wherein the crystal plane forming step may include a step of performing CVD with the substrate set to a predetermined temperature in an environment containing methane and hydrogen. This method enables color centers to be formed on the (111) and (-1-11) crystal planes, which have a larger area than conventional ones, and improves detection sensitivity.

(7) In (6) above, CVD in the CVD step may be performed such that an $\alpha$ parameter which represents a ratio between a growth rate in a <100> direction and a growth rate in a <111> direction is 2 or more and 3.5 or less. As a result, (111) and (-1-11) crystal planes having a larger area can be formed.

(8) In (6) or (7) above, a volume percentage of the methane relative to the hydrogen may be 1% or more and 20% or less, and the predetermined temperature may be 600°C or higher and 1100°C or lower. As a result, (111) and (-1-11) crystal planes having a larger area can be formed.

(9) In (5) above, the method may further include, between the preparation step and the crystal plane forming step, a step of forming a mask with a predetermined width extending along a <1-10> direction on the (001) crystal plane; an etching step of etching the (001) crystal plane having the mask formed thereon; and a step of removing the mask remaining after the etching, wherein the crystal plane forming step may include a step of performing hydrogen plasma etching. This method enables color centers to be formed on the (111) and (-1-11) crystal planes, which have a larger area than conventional ones, and improves detection sensitivity.

[Details of Embodiments of the Present Disclosure]

In the following embodiments, like parts are denoted by like reference numbers. Their names and functions are also the same. A detailed description thereof therefore will not be repeated.

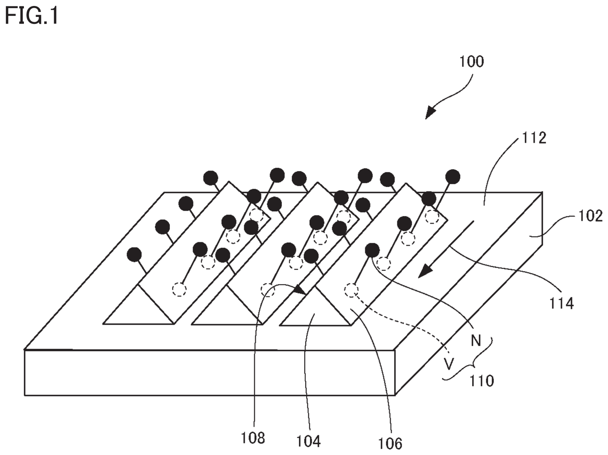

Referring to Fig. 1, a diamond spin sensor 100 according to an embodiment of the present disclosure includes a diamond substrate 102 and a plurality of convex portions 104 formed on diamond substrate 102. A surface 112 is a (001) crystal plane. Convex portions 104 each include a first slope 106 and a second slope 108 located on its back. First slope 106 is a (111) crystal plane, and second slope 108 is a (-1-11) crystal plane. Convex portion 104 is shaped like a triangular prism, and one side surface of the triangular prism is in contact with surface 112. Convex portion 104 extends along a <1-10> direction indicated by arrow 114.

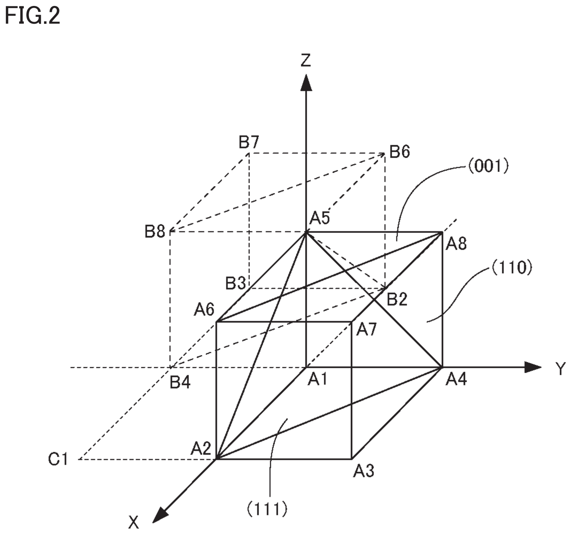

Referring to Fig. 2, the (001) crystal plane in diamond is a plane defined by points A5, A6, A7, and A8. The (111) crystal plane is a plane defined by points A5, A2, and A4. The (-1-11) crystal plane is a plane defined by points B2, B4, and A5. The <1-10> direction is, for example, a direction through points A1 and C1.

As will be described later, convex portion 104 may extend along a <110> direction. In that case, first slope 106 is a (1-11) crystal plane, and second slope 108 is a (-111) crystal plane. Referring to Fig. 2, the <110> direction is, for example, a direction through points A1 and A3. The (1-11) crystal plane is a plane defined by points A5, B4, and A2. The (-111) crystal plane is a plane defined by points A5, A4, and B2. It should be noted that there are two combinations of the direction of extension of convex portion 104 and the crystal planes of first slope 106 and second slope 108 as described above, but they are rotationally symmetric (specifically, fourfold symmetric) and are the same.

First slope 106 and second slope 108 include an NV center 110 having nitrogen N and vacancy V. Many of a plurality of NV centers 110 included in first slope 106 have an axis through N and V (hereafter referred to as the NV axis) that is perpendicular to first slope 106. Many of a plurality of NV centers 110 included in second slope 108 have an NV axis perpendicular to second slope 108.

As described below, N replacing C in a diamond single crystal can take four positions with respect to V.

Thus, the NV axis can take four directions. As described above, many of the NV centers included in first slope 106 and second slope 108 have the NV axis perpendicular to each surface. As described below, the number of NV centers with the NV axis perpendicular to each surface depends on a production process. For example, the proportion of the number of NV centers with the NV axis perpendicular to each surface is preferably about twice or more relative to the number of NV centers with the NV axes facing the other three directions. This configuration provides diamond spin sensor 100 having a plurality of NV centers aligned in the NV axis of the NV centers and capable of improving detection sensitivity.

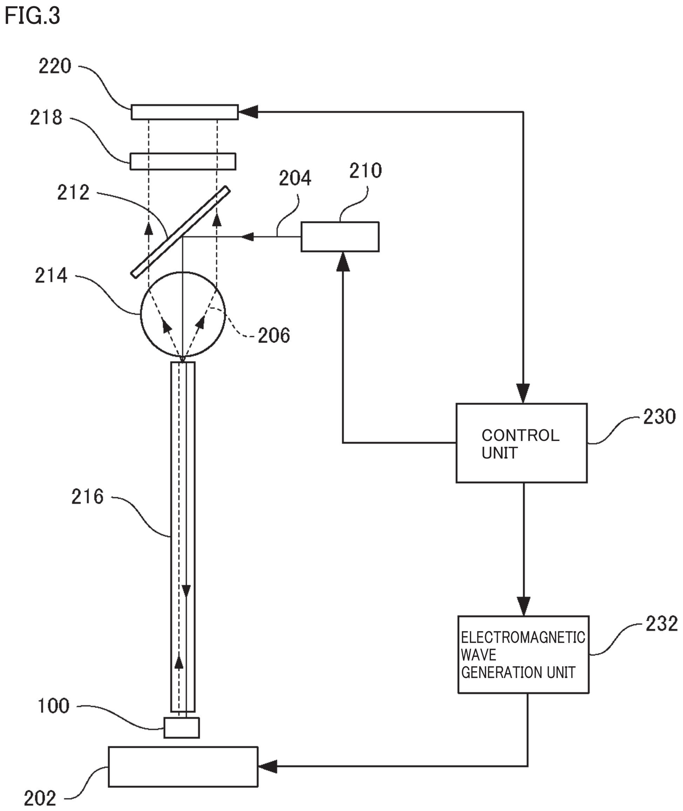

The measurement using diamond spin sensor 100 is performed, for example, with a configuration shown in Fig. 3. A control unit 230 includes a central processing unit (CPU) and a storage unit (neither shown). The processing described later that is performed by control unit 230 is implemented by the CPU reading and executing a program stored in advance in the storage unit.

An excitation light generation unit 210 generates excitation light for exciting an NV center of diamond spin sensor 100 under the control of control unit 230. Control unit 230, for example, supplies excitation light generation unit 210 with a voltage for causing excitation light generation unit 210 to emit light at predetermined timing. Excitation light 204 is green light (i.e., a wavelength of 490 to 560 nm). Excitation light 204 is preferably laser light, and excitation light generation unit 210 is preferably a semiconductor laser (e.g., emitted light with a wavelength of 532 nm).

A filter 212 is an element for separating excitation light 204 incident from excitation light generation unit 210 and the light (i.e., fluorescence) emitted from diamond spin sensor 100 as described later. For example, filter 212 is a filter that cuts (i.e., reflects) light with a wavelength equal to or shorter than a predetermined wavelength and passes light with a wavelength longer than the predetermined wavelength, or a band-pass filter that passes light with a wavelength within a predetermined wavelength range and cuts (i.e., reflects) light with a wavelength outside the predetermined range. This configuration is preferred because excitation light generally has a shorter wavelength than fluorescence. Filter 212 is preferably a dichroic mirror having such a function.

A light collecting element 214 collects excitation light 204 input from filter 212. Light collecting element 214 is, for example, a spherical lens. Light collecting element 214 inputs the excitation light diffusively output from excitation light generation unit 210 as much as possible to an end of an optical waveguide 216. Optical waveguide 216 includes a medium that transmits light and transmits light in both directions. In other words, optical waveguide 216 has a first end and a second end, and transmits excitation light 204 incident on the first end to the second end located near diamond spin sensor 100. Optical waveguide 216 also transmits emitted light (i.e., fluorescence) from diamond spin sensor 100 and incident on the second end to the first end and outputs the emitted light. Optical waveguide 216 is, for example, an optical fiber.

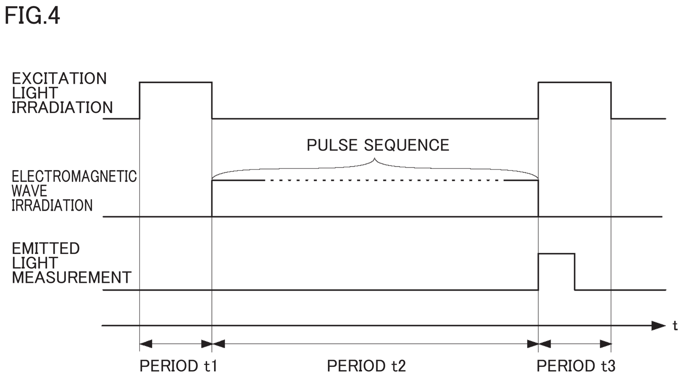

An electromagnetic wave irradiation unit 202 irradiates diamond spin sensor 100 with electromagnetic waves (e.g., microwaves). Electromagnetic wave irradiation unit 202 is, for example, a coil formed by including an electrical conductor. Electromagnetic waves are supplied from an electromagnetic wave generation unit 232 to electromagnetic wave irradiation unit 202, for example, through a coaxial cable. The irradiation of diamond spin sensor 100 with the excitation light and the electromagnetic waves is controlled by control unit 230, for example, at the timing shown in Fig. 4.

Referring to Fig. 4, control unit 230 controls excitation light generation unit 210 to output excitation light for a predetermined period of time (e.g., period t1) at predetermined timing. Control unit 230 controls electromagnetic wave generation unit 232 to output electromagnetic waves for a predetermined period of time (e.g., period t2) at predetermined timing. An appropriate pulse sequence in period t2 may be used as appropriate. With this configuration, the diamond is irradiated with electromagnetic waves in combination in time and space with excitation light. As will be described later, control unit 230 captures an output signal input from a light detection unit 220 at predetermined timing (e.g., within period t3) and stores the output signal in the storage unit.

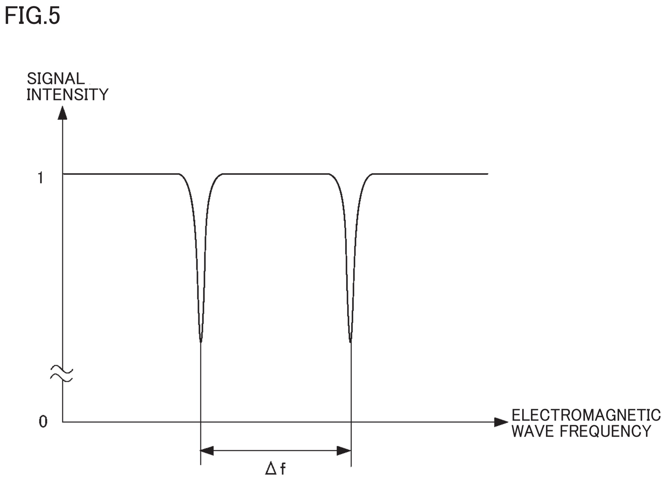

The NV center transitions from the ground state to the excited state by green light with a wavelength of 490 nm to 560 nm (e.g., laser light of 532 nm), emits red light with a wavelength of 630 nm to 800 nm (e.g., fluorescence of 637 nm), and returns to the ground state. The NV center forms a spin-triplet state with a magnetic quantum number $m_s$ of -1, 0, or +1 in a state in which one electron is captured (i.e., NV$^-$), and in the presence of a magnetic field, the energy levels of the $m_s = \pm 1$ state separate according to the magnetic field strength (i.e. Zeeman separation). The NV center is irradiated with a microwave at 2.87 GHz to induce a transition from the $m_s = 0$ state to the $m_s = \pm 1$ state (i.e., electron spin resonance), and then excited by being irradiated with green light. This results in a decrease in the intensity of the emitted light observed because the transition back to the ground state includes a transition that does not emit light (i.e., fluorescence). Therefore, a valley (i.e., a drop in signal) is observed in an electron spin resonance (ESR) spectrum. As described above, control unit 230 controls excitation light generation unit 210 and electromagnetic wave generation unit 232 so that a spectrum, for example, as shown in Fig. 5 is measured. The observed $\Delta f$ between two valleys depends on the magnetic field strength at the location of diamond spin sensor 100. Control unit 230 can calculate a magnetic field from $\Delta f$.

A long pass filter (LPF) 218 is a long-pass filter and passes light with a wavelength equal to or longer than a predetermined wavelength and cuts (e.g., reflects) light with a wavelength shorter than the predetermined wavelength. Fluorescence 206 which is emitted light from diamond spin sensor 100 is red light and passes through LPF 218, but excitation light 204 output from excitation light generation unit 210 has a shorter wavelength than it and does not pass through LPF 218. This configuration prevents excitation light 204 emitted from excitation light generation unit 210 from being detected by light detection unit 220 and becoming noise, and reducing the sensitivity of detecting fluorescence 206 which is emitted light from diamond spin sensor 100. Light detection unit 220 generates and outputs an electrical signal according to incident light. Light detection unit 220 is, for example, a photodiode. An output signal from light detection unit 220 is acquired by control unit 230.

In the above, it has been explained that a magnetic field can be calculated from changes in the ESR spectrum. It is known that the resonance frequency of NV centers has a temperature dependence in the range from 120 K to 700 K. For example, as disclosed in NPL 3, temperature can be measured from a frequency change in an optically detected magnetic resonance (ODMR) signal.

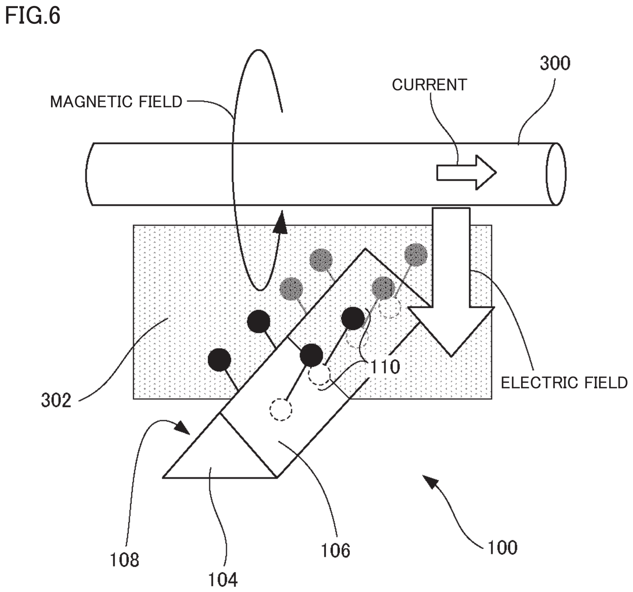

Referring to Fig. 6, when diamond spin sensor 100 is used to measure an electric field generated by current, diamond spin sensor 100 is disposed such that the direction of extension of convex portion 104 is orthogonal to a conductive line 300, which is a predetermined portion of a conductive line through which current flows. The predetermined portion is not limited to a portion of a conductive line, but may be the entire conductive line. That is, as described above, first slope 106 and second slope 108 are (111) and (-1-11) crystal planes, respectively, and diamond spin sensor 100 is disposed such that conductive line 300 is located in a plane defined by the <111> and <-1-11> directions orthogonal to these crystal planes. The plane defined by two directions means a plane that includes the two directions. As described above, a plurality of NV centers 110 present on each of first slope 106 and second slope 108 of convex portion 104 have the NV axis aligned in a direction perpendicular to each surface, and there are two directions in which the NV axis is aligned on the convex portion 104. That is, first slope 106 is the (111) crystal plane, and the NV axis of each NV center formed on first slope 106 is aligned in the <111> direction, which is a direction perpendicular to first slope 106. Second slope 108 is the (-1-11) crystal plane, and the NV axis of each NV center formed on second slope 108 is aligned in the <-1-11> direction, which is a direction perpendicular to second slope 108. When diamond spin sensor 100 is disposed in this manner, NV centers 110 present on first slope 106 and second slope 108 are included in a plane 302 passing through conductive line 300.

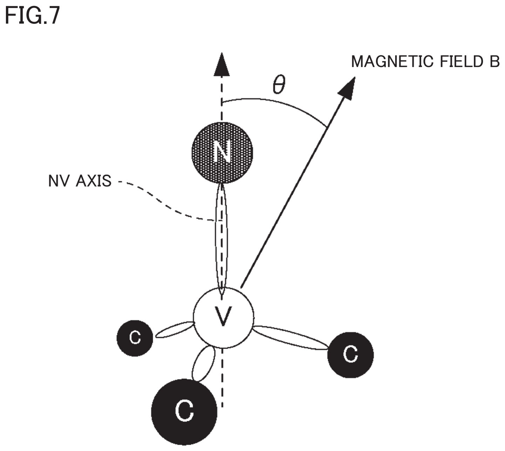

The current flowing through conductive line 300 forms a magnetic field vector around conductive line 300 in a tangential direction of a concentric circle around conductive line 300, and the magnetic field vector formed at a position in plane 302 is orthogonal to plane 302. Referring to Fig. 7, the magnetic field detected by the NV center is a component in the NV axis direction. That is, a change in signal intensity (i.e., fluorescence intensity) according to Bcosθ is detected by diamond spin sensor 100, where θ is the angle formed by magnetic field vector B and the NV axis. In a state in which diamond spin sensor 100 is disposed with respect to conductive line 300 as shown in Fig. 6, the magnetic field formed in plane 302 has no component in plane 302. Therefore, since the angle θ is 90 degrees and cosθ = 0, the magnetic field formed by the current flowing through conductive line 300 is not detected by diamond spin sensor 100 (i.e., NV center 110).

On the other hand, the NV center can detect a component of an electric field in a direction orthogonal to the NV axis. In a state in which diamond spin sensor 100 is disposed with respect to conductive line 300 as shown in Fig. 6, the electric field formed in plane 302 has a component orthogonal to the NV axis. Thus, the electric field can be detected by diamond spin sensor 100 (i.e., NV center 110). That is, when diamond spin sensor 100 is disposed with respect to conductive line 300 as shown in Fig. 6, diamond spin sensor 100 can measure the electric field without being affected by the magnetic field.

Similarly, in measuring temperature, when diamond spin sensor 100 is disposed with respect to conductive line 300 as shown in Fig. 6, diamond spin sensor 100 (i.e., NV center 110) can measure the temperature around conductive line 300 without being affected by the magnetic field formed by the current flowing through conductive line 300. Therefore, if the direction of the magnetic field is known in advance or predictable, the temperature can be accurately measured without being affected by the magnetic field if diamond spin sensor 100 is disposed such that the direction of extension of convex portion 104 is orthogonal to the magnetic field.

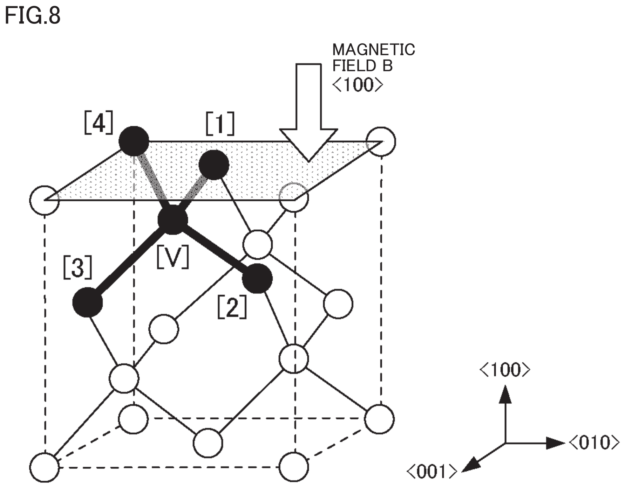

As described above, there are four directions that the NV axis of the NV center can take. In diamond spin sensor 100, the proportion of the number of NV centers with the NV axis perpendicular to each surface of first slope 106 and second slope 108 is about twice or more relative to the number of NV centers with the NV axes facing the other three directions. This proportion can be evaluated by measurement. Referring to Fig. 8 to Fig. 13, it will be explained that a distribution of the NV axes of the NV centers disposed on convex portion 104 and first slope 106 of diamond spin sensor 100 can be estimated by changing the direction of a magnetic field applied externally to diamond spin sensor 100 while performing ODMR, and observing a detected signal.

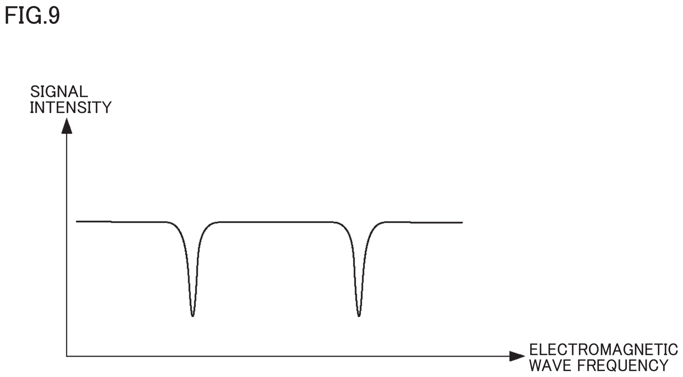

Fig. 8 shows magnetic field B applied in the <100> direction in a diamond crystal structure. The crystal axes are shown in the lower right. In Fig. 8, [V] with square brackets represents a vacancy, and numbers [1] to [4] with square brackets represent four possible positions of nitrogen (N) with respect to [V]. When a diamond containing N in equal proportions at positions [1] to [4] is used to perform ODMR with magnetic field B applied as shown in Fig. 8, a graph having two valleys is obtained as shown in Fig. 9. This is because the angles θ formed by the NV axis with magnetic field B in the <100> direction when N is in positions [1] to [4] are all θ = 54.7 (degrees). That is, the same magnetic field strength is detected by the NV sensor with N in positions [1] to [4], so the frequency (i.e., the distance between two valleys) proportional to the magnetic field strength is equal.

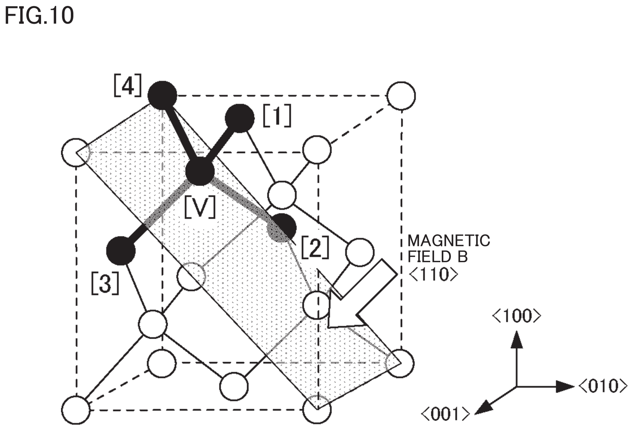

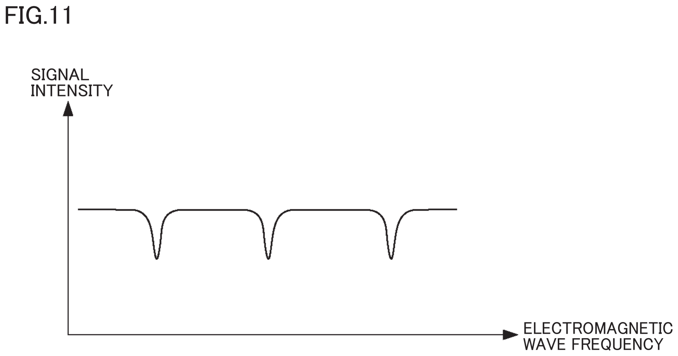

Fig. 10 shows magnetic field B applied in the <110> direction in a diamond crystal structure. The crystal axes are the same as in Fig. 8. Similarly, when a diamond containing N in equal proportions at positions [1] to [4] is used to perform ODMR with magnetic field B applied as shown in Fig. 10, a graph having three valleys is obtained as shown in Fig. 11. This is because the angles θ formed by the NV axis with magnetic field B in the <110> direction when N is in positions [1] to [4] are 35.3, 90.0, 35.3, and 90.0 degrees, respectively. θ is either 35.3 or 90.0 degrees. That is, two magnetic field strengths are detected by the NV sensor with N in positions [1] to [4], so two frequencies (i.e., the distance between two valleys) proportional to the magnetic field strength are detected. The valleys on both sides of Fig. 11 are detected by the NV centers with the NV axis of θ = 35.3 (degrees). The valley in the middle is detected by the NV centers with the NV axis of θ = 90.0 (degrees) and is an overlap of two valleys (Δf = 0 in Fig. 5).

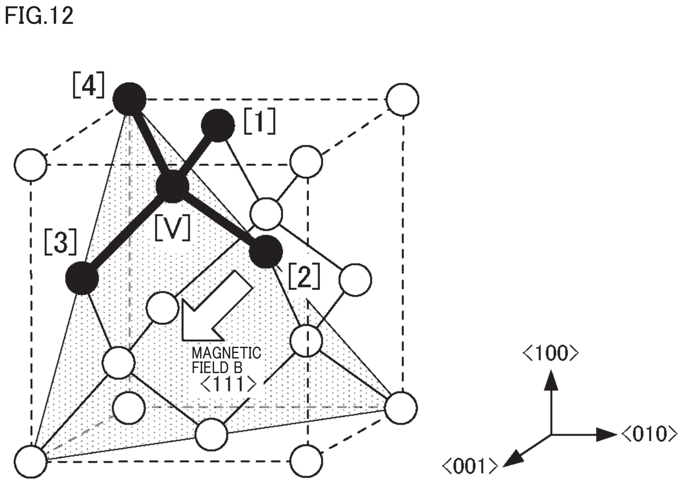

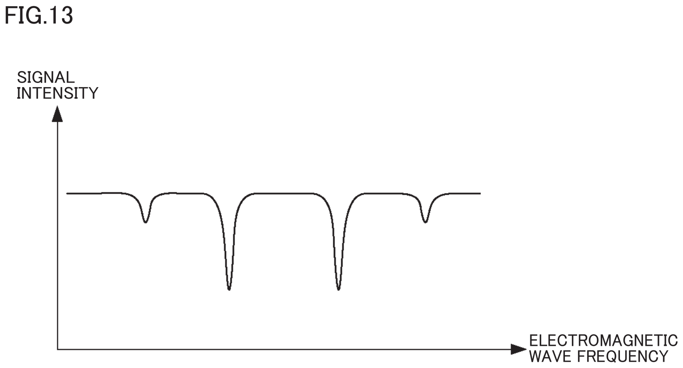

Fig. 12 shows magnetic field B applied in the <111> direction in a diamond crystal structure. The crystal axes are the same as in Fig. 8. Similarly, when a diamond containing N in equal proportions at positions [1] to [4] is used to perform ODMR with magnetic field B applied as shown in Fig. 12, a graph having four valleys is obtained as shown in Fig. 13. This is because the angles θ formed by the NV axis with magnetic field B in the <111> direction when N is in positions [1] to [4] are 0.0, 70.5, 70.5, and 70.5 degrees, respectively. That is, θ is either 0.0 or 70.5 degrees. The valleys at the left and right ends of Fig. 13 are detected by the NV centers with the NV axis of θ = 0.0 (degrees). The two valleys inside are detected by the NV centers with the NV axis of θ = 70.3 (degrees). If θ = 70.3 (degrees), the value of cosθ is smaller than when θ = 0.0 (degrees) and the drop in signal intensity is smaller, but the drop in signal intensity is larger than the valleys at the left and right ends because it is detected by the NV centers with N located at three positions [2] to [4].

The magnitude of the valley drop (i.e., signal intensity) shown in Figs. 9, 11, and 13 corresponds to the intensity of fluorescence emitted from the NV centers and depends on the proportions of four NV axis directions in the diamond. Therefore, ODMR may be performed by changing the direction of a magnetic field applied to the diamond crystal structure, and the proportion of the NV axis direction may be calculated from the observed valleys (specifically, the degree of drop).

(First Method of Producing Diamond Spin Sensor)

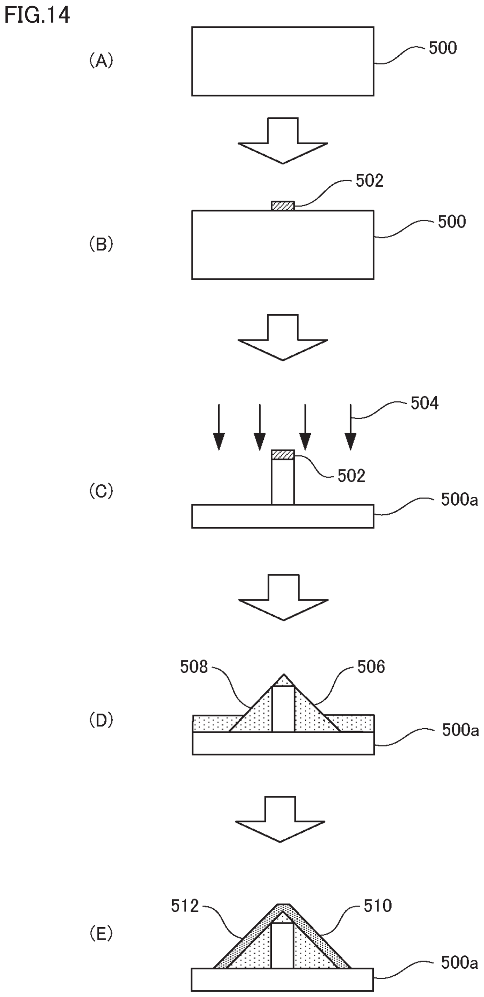

A method of producing the diamond spin sensor shown in Fig. 1 will be described. Referring to Fig. 14, in step (A), a diamond substrate 500 of a predetermined size is prepared. Specifically, an Ib-type diamond single crystal synthesized by a high-pressure high-temperature (HPHT) method is cut and polished by laser so that (001) is the main plane. Furthermore, a mixture of concentrated sulfuric acid and concentrated nitric acid is used for cleaning to prepare diamond substrate 500. Diamonds are classified according to the presence or absence of impurities and the type of impurities. The Ib-type diamond contains nitrogen atoms as impurities (that is, having NV centers).

Following step (A), in step (B), aluminum (Al) is deposited on a surface (i.e., (001) plane) of diamond substrate 500, for example, by sputtering, patterned by photolithography, and etched using buffered hydrofluoric acid to form a rectangular mask 502 (i.e., Al mask). Mask 502 is formed, for example, to extend in the <1-10> direction with respect to the diamond crystal. The dimensions of mask 502 are, for example, 3 μm wide and 100 μm long. A plurality of masks 502 may be formed in parallel. A plurality of masks 502 may be formed, for example, such that 10 masks are separated from each other by 10 μm. Mask(s) 502 may be formed to extend in the <110> direction with respect to the diamond crystal.

The mask material is not limited to Al, but may be tungsten (W), $SiO_2$, or the like. The etching material is not limited to buffered hydrofluoric acid, but may be alkali or the like, and an appropriate material may be used depending on the mask material.

Following step (B), in step (C), diamond substrate 500 is scraped by dry etching using a reactive ion etching (RIE) method to form a wall surface along the rectangular mask 502. A gas mixture of carbon tetrafluoride ($CF_4$) and oxygen (Oz) can be used as a gas for dry etching. The mixing ratio (by volume) is, for example, $CF_4/O_2$ = 2%. The pressure of the gas mixture is, for example, 1 Pa. With an RF power of 300 W, for example, dry etching is performed for 1 hour, for example. Mask 502 remaining after dry etching is removed. Diamond substrate 500 is etched by cations 504 of $CF_4$. A diamond substrate 500a results from the etching on diamond substrate 500. Etching conditions are not limited to the above. Etching conditions may include a mixing ratio of $CF_4/O_2$ = 1% to 50%, a gas mixture pressure of 0.1 Pa to 100 Pa, and an RF power of 100 W to 3 kW.

In step (D), diamond substrate 500a formed by step (C) is installed in a microwave plasma CVD system to perform (001) oriented growth. As a result, first slope 506 having a long (111) crystal plane and second slope 508 having a (-1-11) crystal plane on the back of first slope 506 are formed along the wall surface formed by step (C). For example, first slope 506 and second slope 508 are grown in an environment with a gas mixture of methane ($CH_4$) and hydrogen ($H_2$) (a mixing ratio of

$CH_4/H_2 = 8\%$), a pressure of 100 Torr (about 13.3 kPa), a microwave power of 2 kW, and a substrate temperature of 800°C. To form (111) and (-1-11) crystal planes by (001) oriented growth, it is preferable to perform CVD using low-temperature and high-concentration $CH_4$.

When mask 502 is formed to extend in the <1-10> direction with respect to the diamond crystal, as described above, first slope 506 having a (111) crystal plane and second slope 508 having a (-1-11) crystal plane are formed. When mask 502 is formed to extend in the <110> direction with respect to the diamond crystal, first slope 506 having a (1-11) crystal plane and second slope 508 having a (-111) crystal plane are formed.

Following step (D), in step (E), (111) oriented growth is performed in a microwave plasma CVD system while adding nitrogen (N) to form a first NV layer 510 and a second NV layer 512 having oriented NV centers on the surfaces of first slope 506 (i.e., (111) crystal plane) and second slope 508 (i.e., (-1-11) crystal plane), respectively. That is, NV centers having the NV axis perpendicular to the surface of first NV layer 510 are formed on first NV layer 510. NV centers having the NV axis perpendicular to the surface of second NV layer 512 are formed on second NV layer 512. For example, a gas mixture of $CH_4$, $H_2$, and $N_2$ is used for growth, with a gas composition of $CH_4/H_2 = 0.05\%$, $N_2/CH_4 = 10\%$, a pressure of 80 Torr (about 10.7 kPa), a microwave power of 3 kW, and a substrate temperature of 900°C. The CVD conditions for forming NV centers having the NV axis perpendicular to the surface are not limited to the above. The CVD conditions may include a gas composition of $CH_4/H_2 = 0.01\%$ to 1% and $N_2/CH_4 = 0.1\%$ to 50%, a pressure of 50 Torr to 200 Torr (about 6.67 kPa to 26.7 kPa), a microwave power of 1 kW to 5 kW, and a substrate temperature of 600°C to 1000°C.

Diamond spin sensor 100 shown in Fig. 1 is produced as described above. That is, diamond spin sensor 100 having a plurality of NV centers aligned in the NV axis of the NV centers and capable of improving detection sensitivity can be produced. Diamond substrates having (100) crystal planes, relatively large in size, can be easily obtained, facilitating the production of diamond spin sensors.

As described above, the first method of producing a diamond spin sensor includes, between step (A) and step (D) of forming crystal planes, step (B) of forming mask 502 with a predetermined width extending along the <110> direction on the (001) crystal plane. The method also includes the etching step of etching the (001) crystal plane with mask 502 formed thereon, and the step of removing mask 502 remaining after the etching (step (C)). Step (D) of forming crystal planes includes a step of performing CVD in an environment at a predetermined temperature containing methane and hydrogen. This method enables the formation of NV centers on the (111) and (-1-11) crystal planes, which have a larger area than conventional ones, and improves the detection sensitivity of the diamond spin sensor.

In step (D), the surfaces oriented in the (111) and (-1-11) planes are formed by setting $\alpha$ parameter, which represents the ratio in growth rate between the <100> direction and the <111> direction, to $\alpha \geq 2$ as the CVD growth condition. The $\alpha$ parameter is defined by the following formula, where $V_{100}$ is the growth rate in the <100> direction (i.e., a direction perpendicular to the (100) plane), and $V_{111}$ is the growth rate in the <111> direction (i.e., a direction perpendicular to the (111) plane).

[Math. 1]

$$\alpha = \frac{V_{100}}{V_{111}} \cdot \sqrt{3}$$

More preferably, $\alpha \geq 2.5$. However, when $\alpha > 3.5$, the surface shape becomes rough. Therefore, $\alpha \leq 3.5$ is preferable. For specific synthesis conditions, the volume percentage of methane relative to hydrogen is not limited to the above values and may be 1% or more and 20% or less. The substrate temperature is not limited to the above values and may be 600°C or higher and 1100°C or lower. As a result, (111) and (-1-11) crystal planes having a larger area can be formed.

The diamond spin sensor produced as described above is used for a sample in an environment with a magnetic field, and the temperature of the sample can be measured without being affected by the magnetic field by installing the diamond spin sensor in a direction in which the magnetic field is orthogonal to the NV axis, and performing ODMR measurement. For example, diamond spin sensor 100 is brought into contact with the sample so that their temperatures become equal, and diamond sensor 100 is irradiated with electromagnetic waves (e.g., microwaves) by electromagnetic wave irradiation unit 202 in the configuration shown in Fig. 3. For example, a resonator such as a coil formed by including an electric conductor or a $\lambda/4$ open stub including copper foil and ceramic may be used as electromagnetic wave irradiation unit 202 to apply microwaves, for example, as an intensity of 0.5 mW or higher. Diamond spin sensor 100 may be irradiated with excitation light output from the light emitting element, for example, as an intensity of 0.1 mW or higher, through optical waveguide 216 such as an optical fiber.

(Second Method of Producing Diamond Spin Sensor)

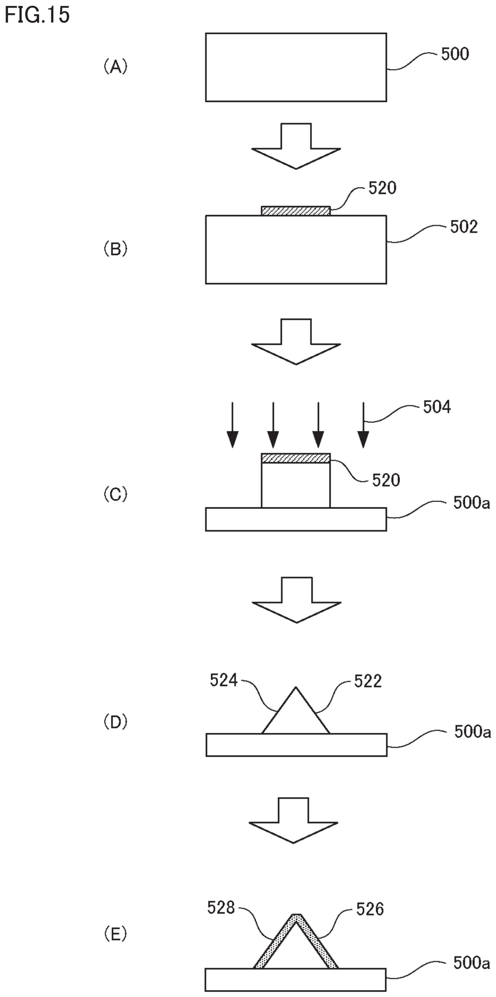

Methods other than the production method shown in Fig. 14 may be used to produce the diamond spin sensor shown in Fig. 1. For example, a production method shown in Fig. 15 may be used. The production method shown in Fig. 15 includes the same processes as those in the production method shown in Fig. 14. Therefore, in the following, the same description will not be repeated and the differences will mainly be described.

Referring to Fig. 15, in step (A), a diamond substrate 500 of a predetermined size is prepared as in step (A) of Fig. 14. Then, in step (B), aluminum (Al) is deposited on a surface (i.e., (001) plane) of diamond substrate 500, patterned by photolithography, and etched to form a rectangular mask 520 (i.e., Al mask) as in step (B) of Fig. 14. Mask 520 is formed to extend in the <110> direction with respect to the diamond crystal. However, mask 520 is wider than mask 502 in Fig. 14. The width of mask 520 is, for example, 4 $\mu$m. A plurality of masks 520 may be formed in parallel. A plurality of masks 520 may be formed, for example, such that 10 masks are separated from each other by 10 $\mu$m.

In step (C), diamond substrate 500 is scraped by dry etching using an RIE method to form a wall surface along the rectangular mask 520, as in step (C) of Fig. 14. Mask 520 remaining after dry etching is removed.

In step (D), diamond substrate 500a formed by step (C) is installed in a microwave plasma CVD system and subjected to anisotropic etching (e.g., plasma etching). As a result, first slope 522 having a long (111) crystal plane and second slope 524 having a (-1-11) crystal plane on the back of first slope 522 are formed along the wall surface formed by step (C). For example, anisotropic etching (i.e., hydrogen plasma etching) is performed using a single gas of hydrogen (100% concentration) at a pressure of 80 Torr (about 10.7 kPa) with a microwave power of 3 kW and a substrate temperature of 950°C.

In step (E), (111) oriented growth is performed in a microwave plasma CVD system while adding nitrogen (N) as in step (E) of Fig. 14. As a result, a first NV layer 526 and a second NV layer 528 having oriented NV centers are formed on first slope 522 (i.e., (111) crystal plane) and second slope 524 (i.e., (-1-11) crystal plane), respectively. That is, NV centers having the NV axis perpendicular to the surface of first NV layer 526 are formed on first NV layer 526. NV centers having the NV axis perpendicular to the surface of second NV layer 528 are formed on second NV layer 528.

Diamond spin sensor 100 shown in Fig. 1 is produced as described above. That is, diamond spin sensor 100 having a plurality of NV centers aligned in the NV axis of the NV centers and capable of improving detection sensitivity can be produced. Diamond substrates having (100) crystal planes, relatively large in size, can be easily obtained, facilitating the production of diamond spin sensors.

As described above, the second method of producing a diamond spin sensor includes, between step (A) and step (D) of forming crystal planes, step (B) of forming mask 520 with a predetermined width extending along the <110> direction on the (001) crystal plane. The method also includes the etching step of etching the (001) crystal plane with mask 520 formed thereon, and the step of removing mask 520 remaining after the etching (step (C)). Step (D) of forming crystal planes includes a step of performing hydrogen plasma etching. This method enables the formation of NV centers on the (111) and (-1-11) crystal planes, which have a larger area than conventional ones, and improves the detection sensitivity of the diamond spin sensor.

In the above, diamond having NV centers is used as diamond. However, the diamond is not limited to this. Any diamond having a color center with electron spin can be used. The color center with electron spin is a center that forms spin triplet states and emits light when excited. NV centers are a typical example of the color center. In addition, color centers with electron spin are known to exist in silicon-vacancy centers (i.e., Si-V centers), germanium-vacancy centers (i.e., Ge-V centers), and tin-vacancy centers (i.e., Sn-V centers). Therefore, a diamond including any of these may be used to configure a diamond spin sensor. This provides a diamond spin sensor having a plurality of color centers aligned in the color center axis and capable of improving detection sensitivity.

The diamond spin sensor produced as described above is used for a sample in an environment with an AC magnetic field and an AC electric field, and the electric field applied to the sample can be measured without being affected by the magnetic field by installing the diamond spin sensor in a direction in which the AC magnetic field is orthogonal to the NV axis, and performing electric field measurement using a pulse sequence. A free induction decay (FID) signal can be used as a magnetic resonance signal. For example, in the configuration shown in Fig. 3, diamond spin sensor 100 is disposed near or within the sample, and diamond spin sensor 100 is irradiated with electromagnetic waves (e.g., microwaves) by electromagnetic wave irradiation unit 202. For example, a resonator such as a coil formed by including an electric conductor or a $\lambda$/4 open stub including copper foil and ceramic may be used as electromagnetic wave irradiation unit 202 to apply, for example, microwaves with an intensity of 0.5 mW or higher. Diamond spin sensor 100 may be irradiated with excitation light output from the light emitting element, for example, as an intensity of 0.1 mW or higher, through optical waveguide 216 such as an optical fiber.

The present disclosure has been explained above with description of the embodiments. However, the foregoing embodiments are illustrative and the present disclosure is not limited to the foregoing embodiments. The scope of the present disclosure is indicated by each of the claims in consideration of the detailed description of the invention, and encompasses the meanings equivalent to the wording therein and all changes in the scope.

REFERENCE SIGNS LIST

    100 diamond spin sensor
    102, 500, 500a diamond substrate

104 convex portion
106, 506, 522 first slope
108, 508, 524 second slope
110 NV Center
112 surface
114 arrow
202 electromagnetic wave irradiation unit
204 excitation light
206 fluorescence
210 excitation light generation unit
212 filter
214 light collecting element
216 optical waveguide
218 LPF
220 light detection unit
230 control unit
232 electromagnetic wave generation unit
300 conductive line
302 plane
502, 520 mask
504 cation
510, 526 first NV layer
512, 528 second NV layer
(A), (B), (C), (D), (E) step
A1, A2, A3, A4, A5, A6, A7, A8, B2, B3, B4, B6, B7, B8, C1 point
N nitrogen
V vacancy
X, Y, Z axis

**Claims**

1. A diamond spin sensor comprising:

   a diamond substrate;
   an inclined surface formed on the diamond substrate, wherein
   color centers with electron spin are formed on the inclined surface, and
   among the color centers formed on the inclined surface, color centers with a color center axis perpendicular to the inclined surface are present in a proportion twice or more color centers with a color center axis not perpendicular to the inclined surface.

2. The diamond spin sensor according to claim 1, wherein the color centers include NV- centers.

3. The diamond spin sensor according to claim 1 or 2, wherein

   the inclined surface comprises a first inclined surface and a second inclined surface,
   the second inclined surface is disposed on back of the first inclined surface,
   the first inclined surface has a (111) crystal plane,
the second inclined surface has a (-1-11) crystal plane,
among the color centers formed on the first inclined surface, color centers with a color center axis perpendicular to the first inclined surface are present in a proportion twice or more color centers with a color center axis not perpendicular to the first inclined surface, and
among the color centers formed on the second inclined surface, color centers with a color center axis perpendicular to the second inclined surface are present in a proportion twice or more color centers with a color center axis not perpendicular to the second inclined surface.

4. The diamond spin sensor according to claim 3, wherein

   in measuring an electric field formed by current flowing through a predetermined portion of a conductive line,
   the diamond spin sensor is disposed with respect to the conductive line such that the predetermined portion is located in a plane defined by a <111> direction and a <-1-11> direction, the <111> direction being a direction normal to the first inclined surface, the <-1-11> direction being a direction normal to the second inclined surface.

5. A method of producing a diamond spin sensor, the method comprising:

   a preparation step of preparing a substrate of a single crystal diamond having a (001) crystal plane on a surface;
   a crystal plane forming step of forming a (111) crystal plane and a (-1-11) crystal plane on the surface of the substrate; and
   an NV forming step of forming NV centers on the (111) crystal plane and the (-1-11) crystal plane by CVD.

6. The method of producing a diamond spin sensor according to claim 5, further comprising, between the preparation step and the crystal plane forming step,

   a step of forming a mask with a predetermined width extending along a <1-10> direction on the (001) crystal plane;
   an etching step of etching the (001) crystal plane having the mask formed thereon; and
   a step of removing the mask remaining after the etching,
   wherein the crystal plane forming step includes a CVD step of performing CVD with the substrate set to a predetermined temperature in an environment containing methane and hydrogen.

7. The method of producing a diamond spin sensor according to claim 6, wherein CVD in the CVD step is performed such that an $\alpha$ parameter is 2 or more and 3.5 or less, the $\alpha$ parameter representing a ratio between a growth rate in a <100> direction and a growth rate in a <111> direction.

8. The method of producing a diamond spin sensor according to claim 6 or 7, wherein

    a volume percentage of the methane relative to the hydrogen is 1% or more and 20% or less, and the predetermined temperature is 600°C or higher and 1100°C or lower.

9. The method of producing a diamond spin sensor according to claim 5, further comprising, between the preparation step and the crystal plane forming step,

    a step of forming a mask with a predetermined width extending along a <1-10> direction on the (001) crystal plane;
    an etching step of etching the (001) crystal plane having the mask formed thereon; and
    a step of removing the mask remaining after the etching,
    wherein the crystal plane forming step includes a step of performing hydrogen plasma etching.

FIG.1

FIG.2

FIG.3

FIG.4

EXCITATION LIGHT IRRADIATION

ELECTROMAGNETIC WAVE IRRADIATION

PULSE SEQUENCE

EMITTED LIGHT MEASUREMENT

t

PERIOD t1          PERIOD t2          PERIOD t3

FIG.5

FIG.6

MAGNETIC FIELD

CURRENT

300

302

108

104

106

110

ELECTRIC FIELD

100

FIG.7

FIG.8

FIG.9

FIG.10

MAGNETIC FIELD B ⟨110⟩

⟨100⟩
⟨010⟩
⟨001⟩

FIG.11

SIGNAL
INTENSITY

ELECTROMAGNETIC
WAVE FREQUENCY

FIG.12

FIG.13

FIG.14

(A)

500

(B)

502

500

(C)

504

502

500a

(D)

508    506

500a

(E)

512    510

500a

## FIG.15

## INTERNATIONAL SEARCH REPORT

| | International application No. |
|---|---|
| | **PCT/JP2024/003395** |

### A. CLASSIFICATION OF SUBJECT MATTER

*G01R 33/20*(2006.01)i; *C30B 29/04*(2006.01)i; *G01R 29/08*(2006.01)i
FI: G01R33/20; C30B29/04; G01R29/08 F

According to International Patent Classification (IPC) or to both national classification and IPC

### B. FIELDS SEARCHED

Minimum documentation searched (classification system followed by classification symbols)

G01R33/00 - 33/26; 29/00 - 29/26; C30B1/00 - 35/00; G01N22/00 - 22/04; 24/00 - 24/14; 33/28 - 33/64

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | WO 2022/210936 A1 (SUMITOMO ELECTRIC INDUSTRIES, LTD.) 06 October 2022 (2022-10-06) <br> paragraphs [0001], [0012], [0090]-[0100], fig. 2-3 | 1-2 |
| Y | JP 2021-193377 A (SOMALOGIC INC.) 23 December 2021 (2021-12-23) <br> paragraph [0033] | 1-2 |
| Y | WO 2015/107907 A1 (JAPAN SCIENCE AND TECHNOLOGY AGENCY) 23 July 2015 (2015-07-23) <br> paragraph [0070], fig. 7(A) | 1-2 |
| A | JP 2009-518273 A (ELEMENT SIX TECHNOLOGIES (PTY) LTD.) 07 May 2009 (2009-05-07) <br> entire text, all drawings | 1-9 |
| A | JP 2020-63960 A (TOKYO INSTITUTE OF TECHNOLOGY) 23 April 2020 (2020-04-23) <br> entire text, all drawings | 1-9 |

☑ Further documents are listed in the continuation of Box C.  ☑ See patent family annex.

| | | |
|---|---|---|
| \* | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **25 March 2024** | **09 April 2024** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

## INTERNATIONAL SEARCH REPORT

International application No.

**PCT/JP2024/003395**

**C.     DOCUMENTS CONSIDERED TO BE RELEVANT**

| Category* | Citation of document, with indication, where appropriate, of the relevant passages | Relevant to claim No. |
|---|---|---|
| A | US 2021/0172739 A1 (ROELVER, Robert et al.) 10 June 2021 (2021-06-10)<br>entire text, all drawings | 1-9 |
| A | CN 107356820 A (DU, Guanxiang et al.) 17 November 2017 (2017-11-17)<br>entire text, all drawings | 1-9 |
| A | US 2021/0149004 A1 (RETZKER, Alex et al.) 20 May 2021 (2021-05-20)<br>entire text, all drawings | 1-9 |

Form PCT/ISA/210 (second sheet) (July 2022)

## INTERNATIONAL SEARCH REPORT
### Information on patent family members

International application No.

**PCT/JP2024/003395**

| Patent document cited in search report | | | Publication date (day/month/year) | Patent family member(s) | | | Publication date (day/month/year) |
|---|---|---|---|---|---|---|---|
| WO | 2022/210936 | A1 | 06 October 2022 | CN | 116997689 | A | |
| JP | 2021-193377 | A | 23 December 2021 | US | 2019/0277842 | A1 | |
| | | | | paragraph [0051] | | | |
| | | | | WO | 2019/173743 | A1 | |
| | | | | KR | 10-2020-0118227 | A | |
| | | | | CN | 112105929 | A | |
| | | | | CA | 3092959 | A1 | |
| WO | 2015/107907 | A1 | 23 July 2015 | US | 2016/0334474 | A1 | |
| | | | | paragraph [0093], fig. 7(A) | | | |
| | | | | EP | 3098335 | A1 | |
| | | | | KR | 10-2016-0111445 | A | |
| | | | | CN | 106414818 | A | |
| JP | 2009-518273 | A | 07 May 2009 | US | 2009/0127506 | A1 | |
| | | | | entire text, all drawings | | | |
| | | | | WO | 2007/066215 | A2 | |
| | | | | CN | 101443476 | A | |
| JP | 2020-63960 | A | 23 April 2020 | US | 2022/0050153 | A1 | |
| | | | | entire text, all drawings | | | |
| | | | | WO | 2020/080362 | A1 | |
| US | 2021/0172739 | A1 | 10 June 2021 | DE | 102019219052 | A1 | |
| | | | | entire text, all drawings | | | |
| CN | 107356820 | A | 17 November 2017 | (Family: none) | | | |
| US | 2021/0149004 | A1 | 20 May 2021 | WO | 2019/211859 | A1 | |
| | | | | CN | 112313522 | A | |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023067532 A

**Non-patent literature cited in the description**

- **M. LESIK** ; **J.-P. TETIENNE** ; **A. TALLAIRE** ; **J. ACHARD** ; **V, MILLE** ; **A. GICQUEL** ; **J.-F. ROCH** ; **V. JACQUES**. Perfect preferential orientation of nitrogen-vacancy defects in a synthetic diamond sample. *Appl. Phys. Lett.*, 2014, vol. 104, 113107
- Development of heavily nitrogen-doped diamond growth with suppression of 2D nucleation. **YUTA NAKANO** ; **SHU INAGAKI** ; **KAZUKI KOBAYASHI** ; **MORIYOSHI HARUYAMA** ; **HIROMITSU KATO** ; **CHRISTOPH E. NEBEL** ; **XUFANG ZHANG** ; **TSUBASA MATSUMOTO** ; **TAKAO INOKUMA** ; **SATOSHI YAMASAKI**. Proceedings of the 69th JSAP (the Japan Society of Applied Physics). Spring Meeting, 2022, 25a-E204, 1

- **M. W. DOHERTY** ; **V. M. ACOSTA** ; **A. JARMOLA** ; **M. S. J. BARSON** ; **N. B. MANSON** ; **D. BUDKER** ; **L. C. L. HOLLENBERG**. Temperature shifts of the resonances of the NV- center in diamond. *PHYSICAL REVIEW B*, 2014, vol. 90 (041201(R))